# EUROPÄISCHE PATENTANMELDUNG

(11) **EP 4 498 565 A1**
(43) Veröffentlichungstag der Anmeldung: **29.01.2025**
(21) Anmeldenummer: 24177139.3
(22) Anmeldetag: 21.05.2024
(51) Int. Cl.: H02J 7/00, G01R 19/00

(54) **VERFAHREN UND VORRICHTUNG ZUR SPANNUNGSPEGELBESTIMMUNG EINES LADESTEUERUNGSSIGNALS**

(30) Priorität: 21.06.2023 DE 102023116188
(71) Anmelder: Lisa Dräxlmaier GmbH, 84137 Vilsbiburg (DE)
(72) Erfinder: Schafferhans, Stephan, 81477 München (DE)

(57) **Zusammenfassung**

Die Offenbarung betrifft ein Verfahren (100) zur Spannungspegelbestimmung eines Ladesteuerungssignals (110) für Ladesysteme von Elektrofahrzeugen, wobei das Ladesteuerungssignal (110) ein pulsweitenmoduliertes, PWM, Signal mit einstellbarer Pulsweite (120) ist, wobei das Verfahren (100) Folgendes umfasst: Erfassen (101) von Messwerten des Ladesteuerungssignals (110) in einem durch ein Messfenster (130) vorgegebenen Zeitbereich; Erkennen (102) einer fallenden Flanke (111) des Ladesteuerungssignals (110) und eines entsprechenden Zeitpunkts (112) der fallenden Flanke (111) basierend auf dem Ladesteuerungssignal (110) und einem vorgegebenen Schwellwert (140); und bei Erkennen der fallenden Flanke (111) des Ladesteuerungssignals (110), Bestimmen eines Spannungspegels (113) des Ladesteuerungssignals (110) basierend auf zumindest einem ersten Teil (115) der in dem Messfenster (130) erfassten Messwerte des Ladesteuerungssignals (110), welche vor dem Zeitpunkt (112) der fallenden Flanke (111) des Ladesteuerungssignals (110) erfasst wurden.

## Beschreibung

### Technisches Gebiet

Die vorliegende Erfindung betrifft ein Verfahren und eine Vorrichtung zur Spannungspegelbestimmung eines Ladesteuerungssignals, insbesondere für Ladesysteme von Elektrofahrzeugen. Die Erfindung betrifft ferner eine optimierte Spannungsmessung eines Signals zur Ladesteuerung.

### Stand der Technik

Das pulsweitenmodulierte (PWM) Ladesteuerungssignal für Ladesysteme nach Typ 1 / CCS 1, Typ 2 / CCS 2 sowie für Megawatt Charging (MCS) muss für den Ladevorgang genau evaluiert werden. Unter anderem ist die Höhe des positiven Spannungssignalpegels zu bestimmen. Aufgrund parasitärer Impedanzen, das heißt Kapazitäten und Induktivitäten im Signalpfad, sowie externer Störeinflüsse ist dieses Signal jedoch oftmals stark verrauscht und kann daher nicht sicher und genau gemessen werden.

Bekannte Lösungen des Problems bestehen beispielsweise in starker Filterung des PWM-Signals, einer kontinuierlichen Abtastung mit nachträglicher Mittelwertbildung per Software sowie der Erfassung mehrerer Messwerte, nachdem eine steigende Flanke erkannt wurde. Diese Lösungen benötigen allerdings viel Rechenzeit des Prozessors, um eine zufriedenstellende Messgenauigkeit zu erreichen. Außerdem ist der Speicherbedarf bei kontinuierlicher Abtastung nicht zu vernachlässigen.

### Beschreibung der Erfindung

Eine Aufgabe der Erfindung ist es daher, eine verbesserte Spannungspegelbestimmung des Ladesteuerungssignals zu schaffen, welche eine genaue Messung des Spannungspegels unter Verringerung des Störeinflusses parasitärer Impedanzen ermöglicht.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Die nachfolgend beschriebene Erfindung ermöglicht die genaue Messung des Spannungspegels unter Verringerung des Störeinflusses parasitärer Impedanzen.

Die erfinderische Lösung basiert auf der Idee, anstatt im Anfangsbereich des High-Pegels, d.h. nach der steigenden Flanke, die Spannung bewusst kurz vor der fallenden Flanke zu messen. Dies wird ermöglicht durch eine kontinuierliche Abtastung des Spannungssignals und die Signalisierung der Spannungsauswertung durch die fallende Flanke des PWM-Signals.

Die im Folgenden beschriebene Erfindung kombiniert die Möglichkeiten einer genauen Spannungsmessung durch eine kontinuierliche, schnelle Abtastung des PWM-Signals zur Ladesteuerung mit der Effizienz und speicheroptimierten Auswertung durch eine begrenzte Anzahl an Messwerten zu einem bestimmten Trigger-Zeitpunkt. Durch die Platzierung des Messfensters am Ende des Spannungsplateaus wird der maximal eingeschwungene Zustand des PWM-Signals genutzt und somit eine größtmögliche Unabhängigkeit vom Einschwingverhalten des Signals ermöglicht.

Gemäß einem ersten Aspekt wird die oben beschriebene Aufgabe gelöst durch ein Verfahren zur Spannungspegelbestimmung eines Ladesteuerungssignals für Ladesysteme von Elektrofahrzeugen, wobei das Ladesteuerungssignal ein pulsweitenmoduliertes, PWM, Signal mit einstellbarer Pulsweite ist, wobei das Verfahren Folgendes umfasst: Erfassen von Messwerten des Ladesteuerungssignals in einem durch ein Messfenster vorgegebenen Zeitbereich; Erkennen einer fallenden Flanke des Ladesteuerungssignals und eines entsprechenden Zeitpunkts der fallenden Flanke basierend auf dem Ladesteuerungssignal und einem vorgegebenen Schwellwert; und bei Erkennen der fallenden Flanke des Ladesteuerungssignals, Bestimmen eines Spannungspegels des Ladesteuerungssignals basierend auf zumindest einem ersten Teil der in dem Messfenster erfassten Messwerte des Ladesteuerungssignals, welche vor dem Zeitpunkt der fallenden Flanke des Ladesteuerungssignals erfasst wurden.

Ein solches Verfahren führt zu einer verbesserten Spannungspegelbestimmung des Ladesteuerungssignals, bei der eine genaue Messung des Spannungspegels unter Verringerung des Störeinflusses parasitärer Impedanzen realisiert wird.

Durch das Platzieren des Messfensters vor der fallenden Flanke des PWM-Signals wird der maximal eingeschwungene Zustand des PWM-Signals genutzt und somit eine größtmögliche Unabhängigkeit vom Einschwingverhalten des Signals ermöglicht. Das Messfenster ist optimal an den eingeschwungenen Zustand des PWM-Signals angepasst und eine Speicherung der Messwerte kann damit ressourcenschonend erfolgen, denn es werden nur Messwerte im eingeschwungenen Zustand zur Bestimmung des Spannungspegels berücksichtigt.

Gemäß einer beispielhaften Ausführungsform des Verfahrens erfolgt das Erkennen der fallenden Flanke des Ladesteuerungssignals basierend auf einem Vergleich des Ladesteuerungssignals oder eines von dem Ladesteuerungssignal abgeleiteten Signals mit dem vorgegebenen Schwellwert.

Der technische Vorteil eines solchen Verfahrens liegt darin, dass die fallende Flanke leicht in Abhängigkeit eines Schwellwertvergleichs erkannt werden kann. Beispielsweise kann dazu ein einfacher Komparator genutzt werden, dem der vorgegebene Schwellwert zugeführt wird.

Gemäß einer beispielhaften Ausführungsform des Verfahrens ist das Messfenster so eingestellt, dass mehrere Messwerte innerhalb eines Teils der Pulsweite des PWM-Signals erfassbar sind.

Der technische Vorteil eines solchen Verfahrens liegt darin, dass mittels der mehreren Messwerte eine genauere Bestimmung des Spannungspegels möglich ist, als wenn nur ein einziger Messwert oder ein paar wenige Messwerte dazu genutzt wird. Eine Mittelung über diese mehreren Messwerte ist daher genauer, als wenn nur einer oder einige wenige Messwerte dazu ausgewertet werden.

Gemäß einer beispielhaften Ausführungsform des Verfahrens ist das Messfenster so eingestellt ist, dass mehrere Messwerte innerhalb eines Teils einer minimal auftretenden Pulsweite des PWM-Signals gemäß der Norm IEC 61851-1 erfassbar sind.

Der technische Vorteil eines solchen Verfahrens liegt darin, dass alle Stromstärken des Ladestroms welche über die Pulsweite des PWM-Signals signalisiert werden, sicher erkannt werden können.

Gemäß einer beispielhaften Ausführungsform des Verfahrens wird der Spannungspegel ohne einen zweiten Teil der in dem Messfenster erfassten Messwerte bestimmt, welche unmittelbar vor dem Zeitpunkt der fallenden Flanke erfasst wurden.

Der technische Vorteil eines solchen Verfahrens liegt darin, dass Messwerte, die bereits im Zeitpunkt der fallenden Flanke erfasst wurden, nicht in die Bestimmung des Spannungspegels mit einfließen, da diese sonst die Bestimmung des Spannungspegels verfälschen würden. Somit kann eine sehr hohe Genauigkeit der Spannungspegelbestimmung garantiert werden. Der Zeitpunkt der fallenden Flanke bezieht sich auf einen erfassten Zeitpunkt, der insbesondere von einem Komparator durch einen Schwellwertvergleich erfasst wurde. Der tatsächliche physikalische Zeitpunkt des Beginns des Abfallens des Ladesteuerungssignal kann hiervon abweichen.

Für den Schwellwertvergleich kann ein Schwellwert verwendet werden, der einen für ein fehlertolerantes Erfassen ausreichenden Abstand zum tatsächlichen positiven Spannungspegel des Ladesteuerungssignals aufweist. Hieraus kann eine Verzögerung entstehen, d.h. der erfasste Zeitpunkt der fallenden Flanke tritt später auf, als das tatsächliche Abfallen des Spannungspegels des Ladesteuerungssignals. Durch das Weglassen des zweiten Teils der in dem Messfenster erfassten Messwerte können nicht zum positiven Spannungspegel gehörende Messwerte, die durch diese Verzögerung gespeichert wurden, bei der Berechnung des Werts des Spannungspegels des Ladesteuerungssignals unberücksichtigt bleiben.

Eine Bestimmung der Länge des zweiten Teils kann auf einer Simulation oder auf Erfahrungswerten beruhen. Die Länge des zweiten Teils kann eine dynamisch angepasste Anzahl an gespeicherten Messwerten oder eine vorbestimmte feste Anzahl gespeicherter Messwerte umfassen, beispielsweise wird der neueste Messwert vor dem Zeitpunkt der fallenden Flanke oder eine andere Anzahl Messwerte vor dem Zeitpunkt der fallenden Flanke verworfen, d.h. diese verworfenen Messwerte bleiben bei der Bestimmung des Spannungspegels des Ladesteuerungssignals unberücksichtigt.

Ebenso ist eine dynamische Testphase, insbesondere bei Inbetriebnahme des Ladesystems, denkbar, in der verschiedene Längen des zweiten Teils nacheinander ausprobiert werden, wobei die Länge des zweiten Teils nach der Testphase auf den Wert gesetzt wird, der in der Testphase den höchsten Spannungspegel ergeben hat und/oder die geringste Varianz des Spannungspegels aufweist.

Gemäß einer beispielhaften Ausführungsform des Verfahrens erfolgt das Bestimmen des Spannungspegels basierend auf einer Mittelwertbildung zumindest des ersten Teils der in dem Messfenster erfassten Messwerte.

Der technische Vorteil eines solchen Verfahrens liegt darin, dass nur die Messwerte kurz vor Auftreten der fallenden Flanke, welche im eingeschwungenen Zustand des PWM-Signals erfasst wurden, zur Mittelwertbildung herangezogen werden. Es werden somit keine Messwertausreißer für die Mittelwertbildung genutzt, welche das Ergebnis verfälschen würden. Die Messgenauigkeit der Spannungspegelbestimmung ist damit sehr hoch.

Gemäß einer beispielhaften Ausführungsform des Verfahrens umfasst das Verfahren ein Filtern des Ladesteuerungssignals vor dem Erfassen der Messwerte, wobei das Filtern mit einem analogen Filter erfolgt, welches ausgebildet ist, Signalüberlagerungen in dem Ladesteuerungssignal durch ein Störsignal, welche beispielsweise von einem Powerline-Signal stammen, zu unterdrücken. Das analoge Filter kann beispielsweise ein Tiefpassfilter sein.

Der technische Vorteil eines solchen Verfahrens liegt darin, dass hochfrequente Schwingungen aufgrund einer Beeinflussung des Ladesteuerungssignals durch eine Powerline-Kommunikation zuvor herausgefiltert werden und so die Bestimmung des Spannungspegels nicht verfälschen können.

Gemäß einer beispielhaften Ausführungsform des Verfahrens umfasst das Verfahren ein Abtasten des gefilterten Ladesteuerungssignals mit einem Analog-Digital-Wandler zum Erhalten der Messwerte des Ladesteuerungssignals; und ein Speichern der abgetasteten Messwerte in einem Pufferspeicher, wobei eine Größe des Pufferspeichers dem durch das Messfenster vorgegebenen Zeitbereich entspricht.

Der technische Vorteil eines solchen Verfahrens liegt darin, dass ein solcher Pufferspeicher effizient an das Messfenster angepasst ist und damit die erfassten Messwerte sehr ressourceneffizient speichern kann. Der Pufferspeicher kann jeweils zuvor erfasste Messwerte durch neue Messwerte überschreiben, so dass zum Zeitpunkt der fallenden Flanke nur die Messwerte im Speicher vorliegen, die im eingeschwungenen Zustand des PWM-Signals erfasst wurden. Der Zeitpunkt, an dem die fallende Flanke einsetzt und der Zeitpunkt, an dem die fallende Flanke erfasst wird, können sich in der Regel voneinander unterscheiden, so dass im Pufferspeicher sich bereits Messwerte befinden, welche in der fallenden Flanke erfasst wurden. Diese wenigen Messwerte können jedoch effizient detektiert werden und von der Bestimmung des Spannungspegels ausgeschlossen werden.

Gemäß einer beispielhaften Ausführungsform des Verfahrens erfolgt das Erkennen der fallenden Flanke basierend auf einem Vergleich des gefilterten Ladesteuerungssignals mit dem vorgegebenen Schwellwert; wobei der vorgegebene Schwellwert einem Signalpegel zwischen einem positiven Spannungspegel und einem negativen Spannungspegel des Ladesteuerungssignals entspricht.

Der technische Vorteil eines solchen Verfahrens liegt darin, dass der Schwellwert mit Kenntnis des positiven Spannungspegels und des negativen Spannungspegels effizient eingestellt werden kann, er kann beispielsweise in der Mitte zwischen positivem und negativem Spannungspegel eingestellt werden.

Gemäß einem zweiten Aspekt wird die oben beschriebene Aufgabe gelöst durch eine Vorrichtung zur Spannungspegelbestimmung eines Ladesteuerungssignals für Ladesysteme von Elektrofahrzeugen, wobei das Ladesteuerungssignal ein pulsweitenmoduliertes, PWM, Signal mit einstellbarer Pulsweite ist, wobei die Vorrichtung Folgendes umfasst: einen Analog-Digital-Wandler zum Erfassen von Messwerten des Ladesteuerungssignals; einen Pufferspeicher zum Speichern der erfassten Messwerte über einen vorgegebenen Zeitbereich; einen Komparator zum Erkennen einer fallenden Flanke des Ladesteuerungssignals basierend auf dem Ladesteuerungssignal und einem vorgegebenen Schwellwert; und einen Prozessor, der ausgebildet ist, bei Erkennen der fallenden Flanke des Ladesteuerungssignals einen Spannungspegel des Ladesteuerungssignals basierend auf zumindest einem ersten Teil der in dem Pufferspeicher gespeicherten Messwerte zu bestimmen, welche vor der fallenden Flanke des Ladesteuerungssignals erfasst wurden.

Der technische Vorteil einer solchen Vorrichtung liegt darin, dass eine verbesserte Spannungspegelbestimmung des Ladesteuerungssignals ermöglicht wird, bei der eine genaue Messung des Spannungspegels unter Verringerung des Störeinflusses parasitärer Impedanzen realisiert werden kann.

Wie bereits oben zum entsprechenden Verfahren gemäß dem ersten Aspekt beschrieben, wird durch das Platzieren des Messfensters vor der fallenden Flanke des PWM-Signals der maximal eingeschwungene Zustand des PWM-Signals genutzt und somit eine größtmögliche Unabhängigkeit vom Einschwingverhalten des Signals ermöglicht. Das Messfenster ist optimal an den eingeschwungenen Zustand des PWM-Signals angepasst und eine Speicherung der Messwerte kann damit ressourcenschonend erfolgen, denn es werden nur Messwerte im eingeschwungenen Zustand zur Bestimmung des Spannungspegels berücksichtigt.

Gemäß einem dritten Aspekt wird die oben beschriebene Aufgabe gelöst durch ein Computerprogrammprodukt, umfassend Befehle, die bei der Ausführung des Programmes durch einen Computer diesen veranlassen, das Verfahren gemäß dem ersten Aspekt auszuführen.

Gemäß einem vierten Aspekt wird die oben beschriebene Aufgabe gelöst durch ein computerlesbares Speichermedium, umfassen Befehle, die bei der Ausführung durch einen Computer diesen veranlassen, das Verfahren gemäß dem ersten Aspekt auszuführen.

### Kurze Figurenbeschreibung

Im Folgenden wird die Erfindung anhand von Ausführungsbeispielen und den Figuren näher beschrieben. Es zeigen:
- Fig. 1a: eine beispielhafte Darstellung eines Control Pilot (CP) Signals 110 mit parasitären Signalanteilen, welches ein Ladesteuerungssignal für ein Ladesystem darstellt;
- Fig. 1b: eine beispielhafte Darstellung des CP-Signals 110 aus Figur 1a nach Filterung mit einem analogen Filter;
- Fig. 2a: eine schematische Darstellung eines erfindungsgemäßen Verfahrens 100 zur Spannungspegelbestimmung eines Ladesteuerungssignals;
- Fig. 2b: eine beispielhafte Darstellung der CP-Signale 110 aus den Figuren 1a und 1b zur Verwendung in dem erfindungsgemäßen Verfahren 100 aus Figur 2a;
- Fig. 3: eine schematische Darstellung eines erfindungsgemäßen Verfahrens 200 zur Spannungspegelbestimmung eines Ladesteuerungssignals gemäß einer beispielhaften Ausführungsform;
- Fig. 4: eine schematische Darstellung eines Pufferspeichers 203 zur Verwendung in dem in Figur 3 dargestellten Verfahren 200; und
- Fig. 5: eine schematische Darstellung einer erfindungsgemäßen Vorrichtung 300 zur Spannungspegelbestimmung eines Ladesteuerungssignals.

Die Figuren sind lediglich schematische Darstellungen und dienen nur der Erläuterung der Erfindung. Gleiche oder gleichwirkende Elemente sind durchgängig mit den gleichen Bezugszeichen versehen.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

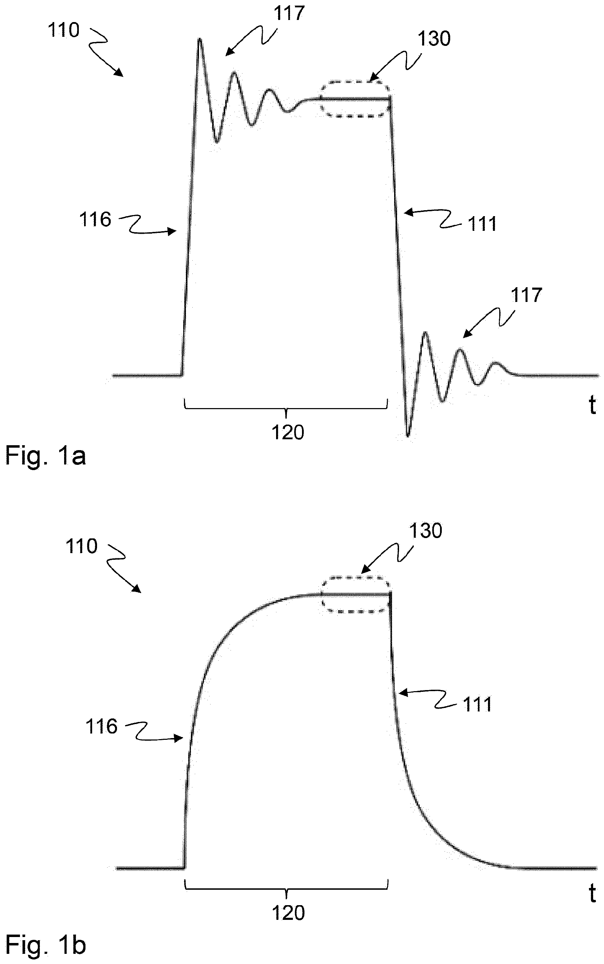

Fig. 1a zeigt eine beispielhafte Darstellung eines Control Pilot (CP) Signals 110 mit parasitären Signalanteilen, welches ein Ladesteuerungssignal für ein Ladesystem darstellt.

Das Control Pilot Signal bzw. Ladesteuerungssignal 110 vermittelt beispielsweise den verfügbaren AC-Ladestrom, d.h. die Stromstärke, welche beispielsweise eine AC-Wallbox zur Verfügung stellen kann.

Auch die Aufforderung zur digitalen Kommunikation wird initial durch den Duty Cycle (d.h. die Pulsweite 120) des PWM-Signals 110 codiert und ist für alle DC-Ladevorgänge bei Typ 1, Typ 2 und MCS-Ladesystemen erforderlich. Hierfür wird ein PWM-Signal mit+12V/-12V und einer Frequenz von 1kHz erzeugt. Zur Auswertung des Signals ist eine möglichst genaue Übertragung der Signalform nötig, was jedoch durch parasitäre Effekte im Signalpfad erschwert wird, wie in Figur 1a ersichtlich.

Parasitäre Impedanzen, d.h. Kapazitäten oder auch Induktivitäten lassen sich in keinem elektrischen Signalpfad komplett vermeiden, insbesondere bei Ladesystemen mit langen Ladekabeln spielen diese jedoch eine besondere Rolle. Die großen Kabellängen sorgen dafür, dass es beispielsweise zu überlagerten Sinusanteilen 117 auf dem ursprünglich rechteckigen PWM-Signal 110 kommt, wie in Figur 1a dargestellt. Diese sind besonders stark ausgeprägt, wenn gerade ein neuer Spannungspegel eingeprägt wird, d.h. nach einer steigenden 116 oder fallenden 111 Flanke des Originalsignals.

Diese Sinusanteile 117 zeigen sich als gedämpfte Schwingung, welche das Rechtecksignal überlagern. Eine Messung des eingeprägten Spannungspegels ist während diesem ersten Zeitbereich nach einer Spannungsflanke 116, 111 nur sehr ungenau, wenn die Schwingungen 117 nicht gezielt herausgefiltert werden.

Fig. 1b zeigt eine beispielhafte Darstellung des CP-Signals 110 aus Figur 1a nach Filterung mit einem analogen Filter.

Eine zu starke Filterung des Signals oder auch ein sehr großer parasitärer Kapazitätsanteil sorgen dagegen für eine stark verschliffene Flanke 116 zu Beginn des Spannungsplateaus, wie in Figur 1b dargestellt. Auch hier wird die Messung des ursprünglichen Signalpegels stark beeinträchtigt.

Um ein möglichst genaues Messergebnis zu erhalten, muss also auf den eingeschwungenen Zustand des Signals gewartet werden. Das optimale Messfenster 130 (gestrichelt markierter Bereich in den Grafiken) liegt somit kurz vor der erneuten Signaländerung, d.h. kurz vor der fallenden Flanke 111 des PWM-Signals 110.

Gängige Lösungen nutzen beispielsweise die steigende Flanke 116 des Signals, um eine ADC-Messung mit einem oder mehreren Messpunkten zu starten. Da ohne Kenntnis des Duty Cycles 120 nicht klar ist, wann genau die fallende Flanke 111 kommen wird, ist es allerdings schwer, diesen Zeitpunkt (bezogen auf die steigende Flanke 116) zu treffen.

Somit gibt es zwei Ansätze: eine feste Totzeit zwischen steigender Flanke 116 und Messungsstart oder eine kontinuierliche Messung mit nachträglicher Bestimmung des optimalen Messzeitpunkts für die Spannungsauswertung.

Im ersten Fall besteht die Herausforderung darin, genügend Abstand zu den Störsignalen im direkten Anschluss an die steigende Flanke 116 einzuhalten und gleichzeitig nicht fälschlicherweise über den Zeitpunkt der fallenden Flanke 111 hinaus zu messen.

Im zweiten Fall ist der Speicherbedarf für die zu erfassenden Messpunkte sehr groß. Da sich die Signalform erst nach 1ms wiederholt, ist es ratsam, für diesen Zeitraum alle Messwerte in einem Pufferspeicher zu behalten und anschließend per Software das geeignete Messfenster auszuwählen und auszuwerten.

Für die Qualität der Messung ist die Abtastrate ein wichtiger Faktor. Je schneller und häufiger das Signal abgetastet wird, desto geringer werden die Einflüsse von Störungen bzw. verrauschten Signalanteilen, da diese über eine Mittelwertbildung herausgefiltert werden können. Eine schnelle Abtastung geht jedoch mit einem großen Speicherbedarf einher, da viele Datenpunkte aufgezeichnet und zwischengespeichert werden müssen.

Der Speicherbedarf kann reduziert werden, indem nur ein begrenztes Zeitfenster 130 im Pufferspeicher vorgehalten wird und diese Messpunkte zu einem geeigneten Zeitpunkt ausgewertet werden. Der bestmögliche Zeitpunkt wird durch die fallende Flanke 111 des zu messenden PWM-Signals 110 markiert.

Im Folgenden wird ein erfindungsgemäßes Verfahren 100 beschrieben, das ein solches begrenztes Zeitfenster 130 zur Erfassung der Messwerte nutzt.

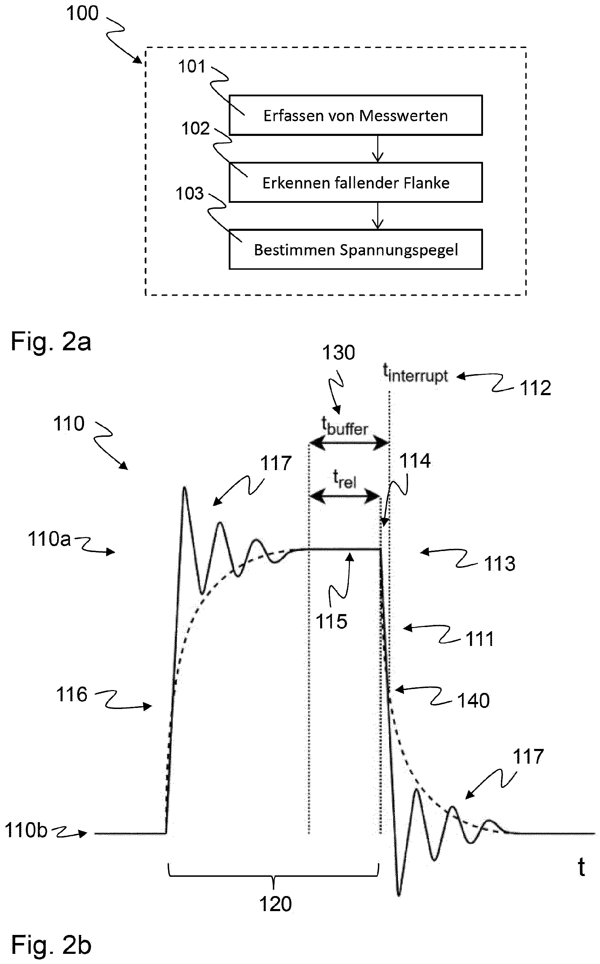

Fig. 2a zeigt eine schematische Darstellung eines erfindungsgemäßen Verfahrens 100 zur Spannungspegelbestimmung eines Ladesteuerungssignals und Fig. 2b zeigt eine beispielhafte Darstellung der CP-Signale 110 aus den Figuren 1a und 1b mit charakteristischen Kenngrößen zur Verwendung in dem erfindungsgemäßen Verfahren 100 aus Figur 2a.

Das Ladesteuerungssignal 110 ist beispielsweise ein pulsweitenmoduliertes Signal, d.h. PWM-Signal, mit einstellbarer Pulsweite 120, das in Ladesystemen von Elektrofahrzeugen eingesetzt wird, beispielsweise gemäß der Norm IEC 61851-1 oder anderer gängiger Normen.

Das Verfahren 100 umfasst die folgenden Schritte:
Erfassen 101 von Messwerten des Ladesteuerungssignals 110 in einem durch ein Messfenster 130 vorgegebenen Zeitbereich;
Erkennen 102 einer fallenden Flanke 111 des Ladesteuerungssignals 110 und eines entsprechenden Zeitpunkts 112 der fallenden Flanke 111 basierend auf dem Ladesteuerungssignal 110 und einem vorgegebenen Schwellwert 140; und
Bei Erkennen der fallenden Flanke 111 des Ladesteuerungssignals 110: Bestimmen eines Spannungspegels 113 des Ladesteuerungssignals 110 basierend auf zumindest einem ersten Teil 115 der in dem Messfenster 130 erfassten Messwerte des Ladesteuerungssignals 110, welche vor dem Zeitpunkt 112 der fallenden Flanke 111 des Ladesteuerungssignals 110 erfasst wurden.

Das Erkennen 102 der fallenden Flanke 111 des Ladesteuerungssignals 110 kann beispielsweise basierend auf einem Vergleich des Ladesteuerungssignals 110 oder eines von dem Ladesteuerungssignal 110 abgeleiteten Signals, zum Beispiel eines Zeitmittelwerts der Messwerte des Ladesteuerungssignals, mit dem vorgegebenen Schwellwert 140 erfolgen.

Das Messfenster 130 kann vorteilhafterweise so eingestellt sein, dass mehrere Messwerte innerhalb eines Teils der Pulsweite 120 des PWM-Signals 110 erfassbar sind.

Beispielsweise kann das Messfenster 130 so eingestellt sein, dass mehrere Messwerte innerhalb eines Teils einer minimal auftretenden Pulsweite 120 des PWM-Signals 110 gemäß der Norm IEC 61851-1 erfassbar sind.

Der Spannungspegel 113 kann beispielsweise ohne einen zweiten Teil 114 der in dem Messfenster 130 erfassten Messwerte bestimmt werden, welche unmittelbar vor dem Zeitpunkt 112 der fallenden Flanke 111 erfasst wurden. Wie in Figur 2b dargestellt handelt es sich bei dem zweiten Teil 114 um die Messwerte, die bereits mit Einsetzen der fallenden Flanke 111 erfasst wurden, jedoch der Schwellwertvergleich mit dem Schwellwert 140 noch nicht angeschlagen hat.

Das Bestimmen des Spannungspegels 113 kann beispielsweise basierend auf einer Mittelwertbildung zumindest des ersten Teils 115 der in dem Messfenster 130 erfassten Messwerte erfolgen. Bei diesem ersten Teil 115 handelt es sich um die bereinigten Messwerte, welche nicht den zweiten Teil 114 umfassen, welche mit Einsetzen der fallenden Flanke 111 erfasst wurden.

Das Verfahren 100 kann ferner ein Filtern des Ladesteuerungssignals 110 vor dem Erfassen 101 der Messwerte umfassen, wobei das Filtern mit einem analogen Filter erfolgt, welches ausgebildet ist, Signalüberlagerungen in dem Ladesteuerungssignal 110, beispielsweise hervorgerufen durch ein Störsignal, beispielsweise ein Powerline-Signal oder ein anderes hochfrequentes Störsignal, zu unterdrücken. Das analoge Filter kann zum Beispiel ein Tiefpassfilter sein, das so eingestellt ist, dass noch die hohen Frequenzen des PWM-Signals 110 durchgelassen werden, nicht mehr aber die hohen Frequenzen des Powerline-Signals.

Das Verfahren 100 kann ferner die folgenden Schritte umfassen:
Abtasten des gefilterten Ladesteuerungssignals mit einem Analog-Digital-Wandler zum Erhalten der Messwerte des Ladesteuerungssignals 110; und
Speichern der abgetasteten Messwerte in einem Pufferspeicher. Eine Größe des Pufferspeichers kann hier dem durch das Messfenster 130 vorgegebenen Zeitbereich entsprechen, wie in Figur 2b dargestellt.

Das Erkennen 102 der fallenden Flanke 111 kann basierend auf einem Vergleich des gefilterten Ladesteuerungssignals mit dem vorgegebenen Schwellwert 140 erfolgen.

Der vorgegebene Schwellwert 140 kann beispielsweise einem Signalpegel zwischen einem positiven Spannungspegel 110a und einem negativen Spannungspegel 110b des Ladesteuerungssignals 110 entsprechen, wie in Figur 2b dargestellt.

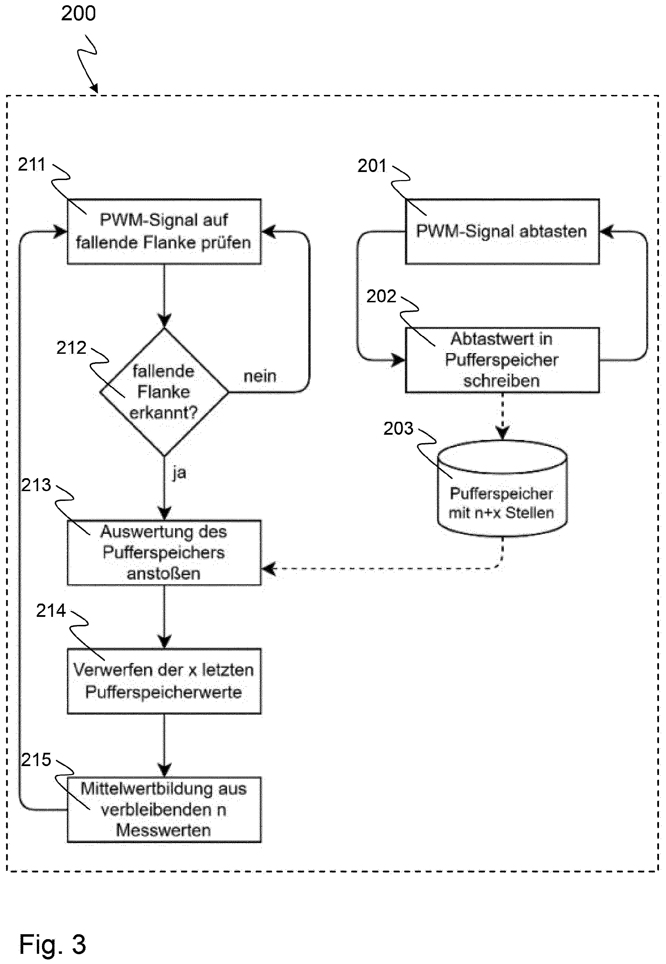

Fig. 3 zeigt eine schematische Darstellung eines erfindungsgemäßen Verfahrens 200 zur Spannungspegelbestimmung eines Ladesteuerungssignals gemäß einer beispielhaften Ausführungsform.

Das Verfahren 200 hat zwei Pfade, einen ersten Pfad mit den Blöcken 201, 202 und 203 und einen zweiten Pfad mit den Blöcken 211, 212, 213, 214 und 215, wobei der zweite Pfad durch den ersten Pfad beeinflusst wird.

Der erste Pfad startet mit dem Abtasten 201 des PWM-Signals, welches den oben zu den Figuren 1a bis 2b beschriebenen PWM-Signalen 110 bzw. Ladesteuerungssignalen 110 entspricht.

Danach erfolgt ein Schreiben 202 des Abtastwertes in einen Pufferspeicher und zum nächsten Abtastzeitpunkt wird ein weiterer Abtastwert des PWM-Signals abgetastet 201 und erneut in den Pufferspeicher geschrieben 202.

Der Pufferspeicher weist nach einem gewissen Wiederholen des Abtastens 201 und Schreibens 202 schließlich eine Anzahl von n+x Stellen bzw. Abtastwerten des PWM-Signals auf.

Der zweite Pfad startet mit einem Prüfen 211 des PWM-Signals auf eine fallende Flanke. Wird im Schritt 212 eine fallende Flanke erkannt, so erfolgt das Anstoßen 213 der Auswertung des Pufferspeichers, wie er im Schritt 203 vorliegt. Andernfalls erfolgt ein erneutes Prüfen 211 des PWM-Signals auf eine fallende Flanke.

Bei der Auswertung des Pufferspeichers werden im Schritt 214 die x letzten Pufferspeicherwerte verworfen. Das heißt, die Länge des zweiten Teils 114 der Pufferspeicherwerte entspricht der Anzahl der x verworfenen Pufferspeicherwerte.

Im anschließenden Schritt 215 erfolgt eine Mittelwertbildung aus den verbleibenden n Messwerten. Nach der Mittelwertbildung 215 liegt ein Spannungspegel des PWM-Signals vor.

Danach erfolgt ein erneutes Prüfen 211 des PWM-Signals auf eine fallende Flanke.

Das Verfahren 200 ist eine spezifische Ausführung des oben zu den Figuren 2a und 2b beschriebenen Verfahrens 100.

Das Erfassen 101 von Messwerten des Ladesteuerungssignals 110 in einem durch ein Messfenster 130 vorgegebenen Zeitbereich entspricht den Schritten 201, 202 und 203, wobei diese erfassten Messwerte im Schritt 203 im Pufferspeicher vorliegen.

Das Erkennen 102 einer fallenden Flanke 111 des Ladesteuerungssignals 110 und eines entsprechenden Zeitpunkts 112 der fallenden Flanke 111 entspricht den Schritten 211 und 212.

Das Bestimmen 103 eines Spannungspegels 113 des Ladesteuerungssignals 110 entspricht den Schritten 213, 214 und 215.

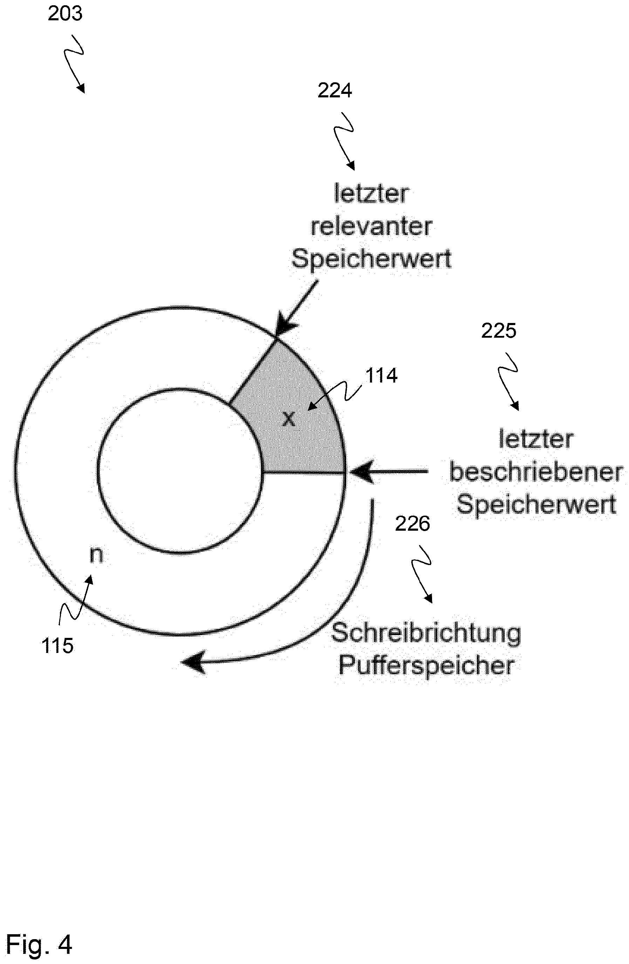

Fig. 4 zeigt eine schematische Darstellung eines Pufferspeichers 203 zur Verwendung in dem in Figur 3 dargestellten Verfahren 200.

Der Pufferspeicher 203 wird entsprechend dem Schritt 203 des in Figur 2 dargestellten Verfahrens 200 verwendet. Nach jeder Abtastung 201 des PWM-Signals 110 liegt ein Messwert bzw. Abtastwert des PWM-Signals 110 vor, der in den Pufferspeicher 203 geschrieben wird. Die Schreibrichtung 226 des Pufferspeichers 203 erfolgt beispielsweise im Uhrzeigersinn, wie in Figur 4 dargestellt. Der nächste Abtastwert zur nächsten Abtastung wird eine Stelle weiter im Uhrzeigersinn in den Pufferspeicher 203 geschrieben.

Im Schritt 203 gemäß Figur 2 sind eine Anzahl von n+x Abtastwerten als Speicherwerte in den Pufferspeicher 203 geschrieben, wobei davon n Abtastwerte 115 relevant sind, nämlich solche, die vor dem Einsetzen der fallenden Flanke 111 in den Pufferspeicher geschrieben wurden, und wobei x Abtastwerte, entsprechend dem zweiten Teil 114, nicht relevant und zu verwerfen sind, nämlich solche, die während oder nach dem Einsetzen der fallenden Flanke 111 noch in den Pufferspeicher geschrieben wurden. Der letzte relevante Speicherwert 224 entspricht dem letzten Abtastwert der n Abtastwerte 115 während der letzte beschriebene Speicherwert 225 dem letzten Abtastwert der x Abtastwerte in dem zweiten Teil 114 entspricht.

Das oben zu Figur 2a und 2b beschriebene Messfenster 130 umfasst somit alle n+x Abtastwerte, die in den Pufferspeicher 203 passen. Der erste Teil 115 der in dem Messfenster 130 erfassten Messwerte gemäß den Figuren 2a und 2b umfasst die n relevanten Abtastwerte 115, während der zweite Teil 114 der in dem Messfenster 130 erfassten Messwerte gemäß den Figuren 2a und 2b die x zu verwerfenden Abtastwerte 114 umfasst, die noch im Pufferspeicher 203 gespeichert wurden, d.h. die Länge des zweiten Teils 114 ist x.

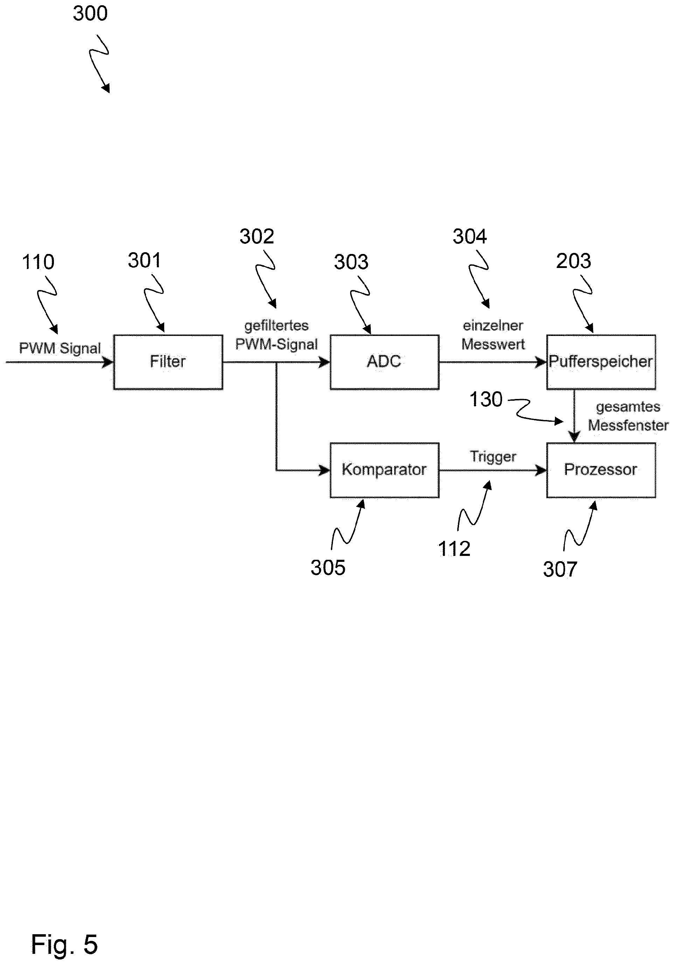

Fig. 5 zeigt eine schematische Darstellung einer erfindungsgemäßen Vorrichtung 300 zur Spannungspegelbestimmung eines Ladesteuerungssignals.

Die Vorrichtung 300 ist analog zu dem oben zu den Figuren 2a und 2b beschriebenen Verfahren 100.

Die Vorrichtung 300 dient zur Spannungspegelbestimmung eines Ladesteuerungssignals 110 für Ladesysteme von Elektrofahrzeugen, wobei das Ladesteuerungssignal 110 ein pulsweitenmoduliertes, PWM, Signal mit einstellbarer Pulsweite 120 ist.

Die Vorrichtung 300 umfasst einen Analog-Digital-Wandler 303 zum Erfassen 101 von Messwerten 304 des Ladesteuerungssignals 110, beispielsweise wie oben zu den Figuren 2a und 2b sowie 3 beschrieben.

Die Vorrichtung 300 umfasst einen Pufferspeicher 203 zum Speichern der erfassten Messwerte über einen vorgegebenen Zeitbereich, beispielsweise wie oben zu den Figuren 3 und 4 näher beschrieben.

Die Vorrichtung 300 umfasst einen Komparator 305 zum Erkennen 102 einer fallenden Flanke 111 des Ladesteuerungssignals 110 basierend auf dem Ladesteuerungssignal 110 und einem vorgegebenen Schwellwert 140, beispielsweise wie oben zu den Figuren 2a, 2b, 3 und 4 beschrieben.

Die Vorrichtung 300 umfasst einen Prozessor 307, der ausgebildet ist, bei Erkennen der fallenden Flanke 111 des Ladesteuerungssignals 110 einen Spannungspegel 113 des Ladesteuerungssignals 110 basierend auf zumindest einem ersten Teil 115 der in dem Pufferspeicher 203 gespeicherten Messwerte 304 zu bestimmen, welche vor der fallenden Flanke 111 des Ladesteuerungssignals 110 erfasst wurden, beispielsweise wie oben zu den Figuren 2a, 2b, 3 und 4 beschrieben.

Optional kann die Vorrichtung 300 ein analoges Filter 301 umfassen, welches ausgebildet ist, das PWM-Signal zu filtern, bevor es als gefiltertes Signal 302 dem AD-Wandler 303 und dem Komparator 305 zugeführt wird.

Das Filter 301 kann ausgebildet sein, das Ladesteuerungssignal 110 vor dem Erfassen 101 der Messwerte zu filtern. Das analoge Filter 301 kann ausgebildet sein, Signalüberlagerungen in dem Ladesteuerungssignal 110 durch ein Störsignal, beispielsweise hervorgerufen durch ein Powerline-Signal, zu unterdrücken.

Der Analog-Digital-Wandler 303 kann ausgebildet sein das gefilterte Ladesteuerungssignal 302 abzutasten, um die Messwerte des Ladesteuerungssignals 110 zu erhalten.

Der Pufferspeicher 203 kann ausgebildet sein, die abgetasteten Messwerte zu speichern. Eine Größe des Pufferspeichers 203 kann dabei dem durch das Messfenster 130 vorgegebenen Zeitbereich entsprechen.

Im Folgenden wird eine Ausführungsform der Vorrichtung 300 näher beschrieben.

Eine vorteilhafte technische Lösung besteht darin, dass ein Mikrocontroller eine kontinuierliche, hochfrequente Abtastung des PWM-Signals 110 durchführt, wobei die einzelnen Abtastwerte 304 direkt in einen Pufferspeicher 203 geschrieben werden. Der vorgesehene Speicherbereich mit n + x Stellen ist dabei kleiner, als es für die Erfassung einer vollständigen Periode des PWM-Signals 110 (etwa 1ms) nötig wäre. Der durch den Pufferspeicher 203 abgedeckte Zeitbereich wird beispielsweise mit t_{buffer} bezeichnet.

Wird das Ende des vorgesehenen Speicherbereichs erreicht, sollen die ältesten Messwerte verworfen und durch neue Abtastwerte ersetzt werden (First In First Out / FIFO-Speicher oder auch Ringspeicher genannt). Um zu ermitteln, wann sich der optimale Signalanteil im Pufferspeicher 203 befindet, wird durch die fallende Flanke 111 des PWM-Signals 110 zum Zeitpunkt tᵢₙₜₑᵣᵣᵤₚₜ 112 (siehe Figur 2b) ein Interrupt im Mikrocontroller erzeugt und der Inhalt des Pufferspeichers 203 verarbeitet.

Dabei kann es vorteilhaft sein, eine Anzahl x der neuesten Messwerte 114 zu verwerfen (wie in Figur 4 dargestellt), da möglicherweise der Beginn der fallenden Flanke 111 mitgemessen wurde und nicht mit in die Auswertung einfließen soll. Der auszuwertende relevante Zeitanteil des Signals wird mit tᵣₑₗ bezeichnet und beinhaltet n Messwerte 115 (wie in Figur 4 dargestellt). Die n Messwerte 115 werden gemittelt und daraus der positive Spannungspegel 110a des PWM-Signals 110 berechnet.

Der Signalfluss kann effektiv in zwei Pfade geteilt werden:
- Ein analoger Signalfluss führt über den ADC 303 in den Pufferspeicher 203;
- Ein digitaler Signalfluss führt über einen Komparator 305 als Trigger direkt in den Prozessor 307.

Um die ADC-Messwerte 304 direkt in den Pufferspeicher 203 zu schreiben ist es vorteilhaft, einen Mikrocontroller mit DMA-Funktionalität zu nutzen. Somit bleibt die Prozessorlast für das Erfassen und Ablegen der einzelnen Messpunkte 304 möglichst niedrig.

Die optimale Größe des Messfensters 130 kann aus dem minimalen zu erfassenden Duty Cycle 120 des PWM-Signals 110 abgeleitet werden. Entsprechend der gängigen Normen (beispielsweise IEC 61851-1) sollte ein minimaler Duty Cycle von 3% bei einer maximalen Frequenz von 1020 Hz noch sauber erfasst werden können. Daraus ergibt sich eine positive Pulsbreite von gut 29 µs. Unter Berücksichtigung der maximal zulässigen Settling Time bzw. Einschwingzeit (d.h. der Dauer bis 95% des Signalpegels erreicht sein sollen) von 3 µs, ergibt sich in einem ungestörten System somit eine minimale Pulsbreite von ca. 26 µs. Werden weitere 10 µs für den Einschwingvorgang des durch parasitäre Impedanzen gestörten Signals berücksichtigt, ergibt sich so ein minimales geeignetes Messfenster von 16 µs. Bei einer Abtastrate von 1 MHz entspricht dies 16 Messwerten innerhalb des Messfensters.

Um auszuschließen, dass die fallende Flanke 111 des Signals 110 mitgemessen wurde, können beispielsweise die letzten beiden Messwerte verworfen werden, was der maximal zulässigen Fall Time bzw. Abfallzeit von 2 µs entspricht. Somit kann der Spannungspegel anhand der verbleibenden 14 Messwerte durch Mittelwertbildung bestimmt werden.

Die oben aufgeführten Zeiten sind nur als ein Beispiel anzusehen. Durch schnellere oder langsamere Abtastung sowie abweichende Annahmen für das optimale Messfenster 130 können sich andere Werte für die Messfenstergröße und die zu erfassenden Werte ergeben.

### BEZUGSZEICHENLISTE

- 100: Verfahren zur Spannungspegelbestimmung
- 101: erster Verfahrensschritt: Erfassen
- 102: zweiter Verfahrensschritt: Erkennen
- 103: dritter Verfahrensschritt: Bestimmen
- 110: Ladesteuerungssignal, PWM-Signal
- 110a: positiver Signalpegel des PWM-Signals
- 110b: negativer Signalpegel des PWM-Signals
- 111: fallende Flanke des PWM-Signals
- 112: Zeitpunkt der fallenden Flanke, tᵢₙₜₑᵣᵣᵤₚₜ
- 113: zu bestimmender Spannungspegel des Ladesteuerungssignals
- 114: zweiter Teil
- 115: erster Teil
- 116: steigende Flanke des PWM-Signals
- 117: sinusförmige Störsignalanteile
- 120: Pulsweite des PWM-Signals, Duty Cyle
- 130: Messfenster
- 140: Schwellwert, Schwellspannungspegel

- 200: Verfahren zur Spannungspegelbestimmung
- 201: erster Block im ersten Pfad: Abtasten
- 202: zweiter Block im ersten Pfad: Schreiben
- 203: dritter Block im ersten Pfad: Pufferspeicher mit n+x Stellen
- 211: erster Block im zweiten Pfad: Prüfen
- 212: zweiter Block im zweiten Pfad: Erkennen
- 213: dritter Block im zweiten Pfad: Auswerten
- 214: vierter Block im zweiten Pfad: Verwerfen
- 215: fünfter Block im zweiten Pfad: Mittelwertbildung
- 224: letzter relevanter Speicherwert
- 225: letzter beschriebener Speicherwert
- 226: Schreibrichtung Pufferspeicher

- 300: Vorrichtung zur Spannungspegelbestimmung
- 301: (analoges) Filter
- 302: gefiltertes PWM-Signal
- 303: Analog-Digital-Wandler
- 304: einzelner Messwert
- 305: Komparator
- 307: Prozessor

## Patentansprüche

1. Verfahren (100) zur Spannungspegelbestimmung eines Ladesteuerungssignals (110) für Ladesysteme von Elektrofahrzeugen, wobei das Ladesteuerungssignal (110) ein pulsweitenmoduliertes, PWM, Signal mit einstellbarer Pulsweite (120) ist, wobei das Verfahren (100) Folgendes umfasst:
Erfassen (101) von Messwerten des Ladesteuerungssignals (110) in einem durch ein Messfenster (130) vorgegebenen Zeitbereich;
Erkennen (102) einer fallenden Flanke (111) des Ladesteuerungssignals (110) und eines entsprechenden Zeitpunkts (112) der fallenden Flanke (111) basierend auf dem Ladesteuerungssignal (110) und einem vorgegebenen Schwellwert (140); und
bei Erkennen (102) der fallenden Flanke (111) des Ladesteuerungssignals (110), Bestimmen (103) eines Spannungspegels (113) des Ladesteuerungssignals (110) basierend auf zumindest einem ersten Teil (115) der in dem Messfenster (130) erfassten Messwerte des Ladesteuerungssignals (110), welche vor dem Zeitpunkt (112) der fallenden Flanke (111) des Ladesteuerungssignals (110) erfasst wurden.

2. Verfahren (100) nach Anspruch 1,
wobei das Erkennen (102) der fallenden Flanke (111) des Ladesteuerungssignals (110) basierend auf einem Vergleich des Ladesteuerungssignals (110) oder eines von dem Ladesteuerungssignal (110) abgeleiteten Signals (302) mit dem vorgegebenen Schwellwert (140) erfolgt.

3. Verfahren (100) nach Anspruch 1 oder 2,
wobei das Messfenster (130) so eingestellt ist, dass mehrere Messwerte innerhalb eines Teils der Pulsweite (120) des PWM-Signals (110) erfassbar sind.

4. Verfahren (100) nach einem der vorstehenden Ansprüche,
wobei das Messfenster (130) so eingestellt ist, dass mehrere Messwerte innerhalb eines Teils einer minimal auftretenden Pulsweite (120) des PWM-Signals (110) gemäß der Norm IEC 61851-1 erfassbar sind.

5. Verfahren (100) nach einem der vorstehenden Ansprüche,
wobei der Spannungspegel (113) ohne einen zweiten Teil (114) der in dem Messfenster (130) erfassten Messwerte bestimmt wird, welche unmittelbar vor dem Zeitpunkt (112) der fallenden Flanke (111) erfasst wurden.

6. Verfahren (100) nach einem der vorstehenden Ansprüche,
wobei das Bestimmen des Spannungspegels (113) basierend auf einer Mittelwertbildung zumindest des ersten Teils (115) der in dem Messfenster (130) erfassten Messwerte erfolgt.

7. Verfahren (100) nach einem der vorstehenden Ansprüche, mit:
Filtern des Ladesteuerungssignals (110) vor dem Erfassen (101) der Messwerte, wobei das Filtern mit einem analogen Filter erfolgt, welches ausgebildet ist, Signalüberlagerungen in dem Ladesteuerungssignal (110), hervorgerufen durch ein Störsignal, insbesondere ein Powerline-Signal, zu unterdrücken.

8. Verfahren (100) nach Anspruch 7, mit:
Abtasten des gefilterten Ladesteuerungssignals (302) mit einem Analog-Digital-Wandler zum Erhalten der Messwerte des Ladesteuerungssignals (110); und
Speichern der abgetasteten Messwerte in einem Pufferspeicher (203), wobei eine Größe des Pufferspeichers (203) dem durch das Messfenster (130) vorgegebenen Zeitbereich entspricht.

9. Verfahren (100) nach Anspruch 7 oder 8,
wobei das Erkennen (102) der fallenden Flanke (111) basierend auf einem Vergleich des gefilterten Ladesteuerungssignals (302) mit dem vorgegebenen Schwellwert (140) erfolgt;
wobei der vorgegebene Schwellwert (140) einem Signalpegel zwischen einem positiven Spannungspegel (110a) und einem negativen Spannungspegel (110b) des Ladesteuerungssignals (110) entspricht.

10. Vorrichtung (300) zur Spannungspegelbestimmung eines Ladesteuerungssignals (110) für Ladesysteme von Elektrofahrzeugen, wobei das Ladesteuerungssignal (110) ein pulsweitenmoduliertes, PWM, Signal mit einstellbarer Pulsweite (120) ist, wobei die Vorrichtung (300) Folgendes umfasst:
einen Analog-Digital-Wandler (303) zum Erfassen (101) von Messwerten (304) des Ladesteuerungssignals (110);
einen Pufferspeicher (203) zum Speichern der erfassten Messwerte über einen vorgegebenen Zeitbereich;
einen Komparator (305) zum Erkennen (102) einer fallenden Flanke (111) des Ladesteuerungssignals (110) basierend auf dem Ladesteuerungssignal (110) und einem vorgegebenen Schwellwert (140); und
einen Prozessor (307), der ausgebildet ist, bei Erkennen (102) der fallenden Flanke (111) des Ladesteuerungssignals (110) einen Spannungspegel (113) des Ladesteuerungssignals (110) basierend auf zumindest einem ersten Teil (115) der in dem Pufferspeicher (203) gespeicherten Messwerte (304) zu bestimmen (103), welche vor der fallenden Flanke (111) des Ladesteuerungssignals (110) erfasst wurden.
